# EUROPÄISCHE PATENTSCHRIFT

(11) **EP 1 775 769 B1**
(45) Veröffentlichungstag und Bekanntmachung des Hinweises auf die Patenterteilung: **24.09.2008**
(21) Anmeldenummer: 06020503.6
(22) Anmeldetag: 29.09.2006
(51) Int. Cl.: H01L 25/07

(54) **Leistungshalbleitermodul**
Power semiconductor module
Module semiconducteur de puissance

(30) Priorität: 12.10.2005 DE 102005050534
(43) Veröffentlichungstag der Anmeldung: 18.04.2007
(73) Patentinhaber: Semikron Elektronik GmbH & Co. KG Patentabteilung, 90431 Nürnberg (DE)
(72) Erfinder: Beckedahl, Peter, 90522 Oberasbach (DE); Göbl, Christian, 90441 Nürnberg (DE); Schloetterer, Andre, 90441 Nürnberg (DE)

(56) Entgegenhaltungen:
- EP-A- 1 511 078
- EP-A1- 0 552 475
- EP-A1- 0 577 264
- EP-A2- 0 064 856
- EP-A2- 1 378 941

## Beschreibung

Die Erfindung beschreibt ein Leistungshalbleitermodul mit steuerbaren Leistungshalbleiterbauelementen. Einen Ausgangspunkt der Erfindung bilden Leistungshalbleitermodule wie sie beispielhaft aus der DE 42 37 632 A1 und der DE 197 19 703 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfskontakte und im Inneren angeordnete Verbindungselemente auf. Diese Verbindungselemente für die schaltungsgerechten Verbindungen im Inneren des Leistungshalbleitermoduls sind meist als Drahtbondverbindungen ausgebildet.

Die steuerbaren Leistungshalbleiterbauelemente sind gemäß dem Stand der Technik mit ihrer zweiten Hauptfläche, die bei bipolaren Leistungshalbleiterbauelementen als Lastanschlussfläche des Kollektors ausgebildet ist, auf eine zugeordnete Leiterbahn des Substrats gelötet und somit elektrisch leitend verbunden. Die erste Hauptfläche des Leistungshalbleiterbauelements weist hier zwei Kontaktflächen auf, wobei eine als Steueranschluss und eine als Lastanschlussfläche des Emitters ausgebildet ist. Sowohl die Steuer- als auch die Emitterkontaktfläche sind mittels Drahtbondverbindungen schaltungsgerecht mit weiteren Leistungshalbleiterbauelementen oder mit weiteren Kontaktflächen elektrisch leitend verbunden.

Nachteilig an Drahtbondverbindungen speziell für Leistungshalbleiterbauelemente mit hoher Stromtragfähigkeit pro Flächeneinheit ist, dass diese eine Vielzahl von Bonddrähten und jeder Bonddraht eine Mehrzahl von Bondfüßen aufweisen muss um die notwendigen Stromtragfähigkeit der Bondverbindung zu erreichen. Weiterhin nachteilig an Bondverbindungen ist, dass die elektrische Verbindung über eine Mehrzahl von voneinander beabstandeten Bondfüßen hergestellt wird und somit der Stromeintrag auf die Kontaktfläche des Leistungshalbleiterbauelements nicht homogen erfolgt.

Ebenfalls bekannt sind druckkontaktierte Leistungshalbleitermodule, wie sie aus der DE 42 37 632 A1 oder der DE 103 60 573 A1 bekannt sind. Bei erstgenannter Druckschrift wird mittels verschiedener Druck einleitender Elemente des Aufbaus das Substrat gegen ein Kühlbauteil gedrückt, um einen wirkungsvollen, elektrisch isolierten, aber thermisch leitenden Kontakt herzustellen und die im Betrieb entstehende Wärme effektiv abzuführen. Die Druckeinleitung erfolgt hierbei auf Bereiche des Substrats, die nicht mit Bauelementen bestückt sind und gesondert frei gehalten werden. Nachteilig hieran ist dass dadurch die für Leistungshalbleiterbauelemente und für Verbindungselemente zur Verfügung stehende Fläche des Substrats durch die Druck einleitenden Elemente beschränkt wird. Weiterhin nachteilig ist, dass die beste thermisch Ankopplung nicht im Bereich der Wärmequelle, dem jeweiligen Leistungshalbleiterbauelement, sondern in benachbarten Bereichen erzielt wird.

In allen vorgenannten Ausgestaltungen von Leistungshalbleitermodulen weisen die Substrate Leiterbahnen mit unterschiedlichen Potentialen, typischerweise die beiden Gleichstrompotentiale und das Wechselstrompotential auf. Weiterhin sind Leiterbahnen mit Hilfspotentialen, beispielhaft Steuerpotentialen, auf dem Substrat angeordnet.

Beispielhaft aus der DE 103 60 573 A1 ist eine Druckanordnung direkt auf ein Leistungshalbleiterbauelement bekannt, wobei zwischen einer Grundplatte und den Druck einleitenden Elementen je ein Leistungshalbleiterbauelement angeordnet ist. Derzeit sind derartige druckkontaktierte Aufbauten, bei denen der Druck direkt auf das Leistungshalbleiterbauelement eingeleitet wird, in praxi meist für Leistungsdioden und Leistungsthyristoren bekannt. Nachteilig an derartigen Aufbauten ist, dass der Druck selektiv für jedes Leistungshalbleiterbauelement getrennt eingeleitet wird.

Aus der EP 0 064 856 A2 ist eine Mehrphasenbrückenanordnung bekannt, die eine Substrat, sowie hierauf eine Mehrzahl von Leiterbahnen mit Lastpotentials, Wechselspannungspotential und auch Gleichspannungspotential. Aus der EP 1 378 941 A2 ist ebenfalls ein Leistungshalbleitermodul in Drei- Phasen- Anordnung bekannt, wobei die Leistungshalbleiterbauelemente direkt auf Wechselspannungspotential liegenden Leiterbahnen angeordnet sind. Die Steueranschlüsse der Leistungshalbleiterbauelemente, die zwischen dem Substrat und einem Anschlusselement angeordnet sind, sind hier aus diesem Stapel seitlich heraus geführt.

Aus der EP 1 511 078 A2 ist ein Leitungshalbleitermodul in Druckkontaktierung bekannt, wobei eine Mehrzahl von aktiven Bauelementen und eine Mehrzahl von Dioden mit entsprechend angeordneten Wärmeleitpuffern zwischen zwei Anschlusselementen derart angeordnet sind, dass sich die Effektivität der Wärmeableitung erhöht.

Der Erfindung liegt die Aufgabe zugrunde ein Leistungshalbleitermodul mit einer Mehrzahl von Leistungshalbleiterbauelementen vorzustellen, das eine effektive Stromzu- und Abführung aufweist, sowie einem einfachen und rationellen Herstellungsprozess zugänglich ist.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke beinhaltet ein Leistungshalbleitermodul zur Anordnung auf einem Kühlbauteil mit mindestens einem Substrat, mindestens zwei steuerbaren Leistungshalbleiterbauelementen, beispielhaft bipolaren Transistoren, einem Gehäuse und nach außen führenden Last- und Steueranschlusselementen. Das Substrat selbst weist einen Isolierstoffkörper auf und auf dessen erster, dem Inneren des Leistungshalbleitermoduls zugewandten Hauptfläche, mindestens eine Leiterbahn mit Lastpotential. Weiterhin weist das Substrat mindestens eine Leiterbahn mit Steuerpotential auf. Die steuerbaren Leistungshalbleiterbauelemente weisen eine erste Hauptfläche mit einer ersten Lastanschlussfläche, beispielhaft dem Emitteranschluss, und mit einer Steueranschlussfläche sowie eine zweite Hauptfläche mit einer zweiten Lastanschlussfläche, beispielhaft dem Kollektoranschluss, auf.

Das erfindungsgemäße Leistungshalbleitermodul weist mindestens ein erstes Leistungshalbleiterbauelement auf, das mit seiner ersten Hauptfläche dem Substrat zugewandt auf diesem angeordnet und mit je einer Last- und einer Steuerpotential aufweisenden Leiterbahn schaltungsgerecht verbunden ist. Weiterhin weist es mindestens ein zweites Leistungshalbleiterbauelement auf, das mit seiner zweiten Hauptfläche dem Substrat zugewandt auf diesem angeordnet und mit einer Lastpotential aufweisenden Leiterbahn schaltungsgerecht verbunden ist. Mindestens ein Lastanschlusselement des erfindungsgemäßen Leistungshalbleitermoduls ist auf einer Lastanschlussfläche eines Leistungshalbleiterbauelements angeordnet und elektrisch leitend mit dieser verbunden.

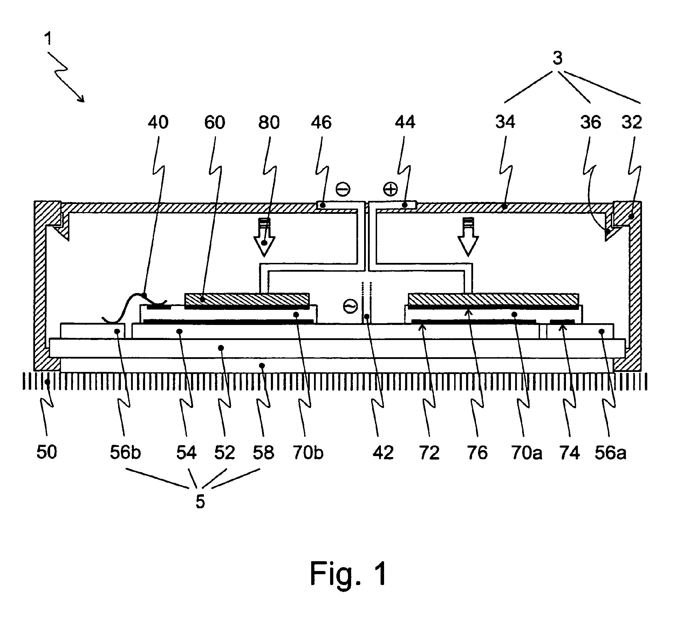

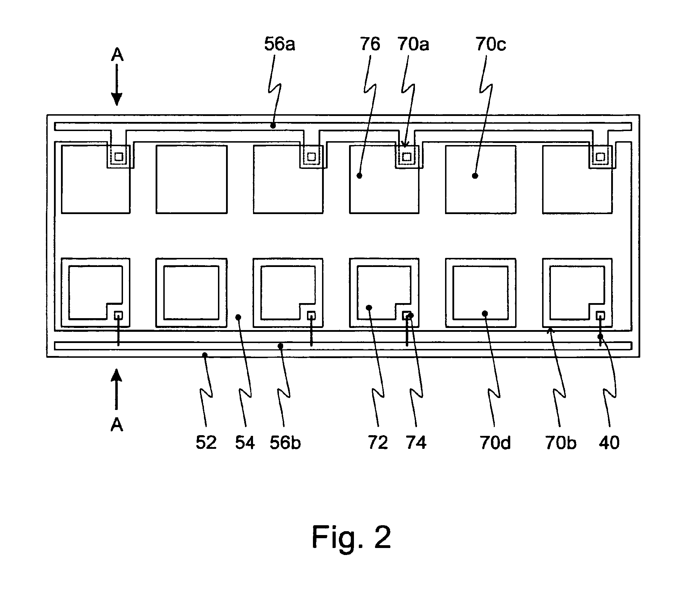

Die erfinderische Lösung wird an Hand der Ausführungsbeispiele der Fig. 1 und 2 weiter erläutert.

Fig. 1 zeigt eine einen Schnitt durch ein erfindungsgemäßes Leistungshalbleitermodul.

Fig. 2 zeigt das Substrat und die Anordnung der Leistungshalbleiterbauelemente eines erfindungsgemäßen Leistungshalbleitermoduls.

Fig. 1 zeigt einen Schnitt entlang der Linie A-A (vgl. Fig. 2) durch ein erfindungsgemäßes Leistungshalbleitermodul (1). Dieses weist ein Gehäuse (3) auf, welches aus einen rahmenartigen Gehäuseteil (32) sowie einem Deckel (34) mit Rastnasen (36) zur Schnapp- Rast- Verbindung mit dem rahmenartigen Gehäuseteil (32) besteht. Der rahmenartige Gehäuseteil (32) umschließt hierbei ein Substrat (5). Dieses wiederum weist einen Isolierstoffkörper (52), vorzugsweise eine Isolierkeramik, wie Aluminiumoxid oder Aluminiumnitrit auf. Auf der, dem Inneren des Leistungshalbleitermoduls (1) zugewandten, ersten Hauptfläche weist das Substrat (5) eine in sich strukturierte Kupferkaschierung auf. Die einzelnen Abschnitte dieser Kupferkaschierung bilden die Leiterbahnen (54, 56 a/b) des Leistungshalbleitermoduls aus. Die zweite Hauptfläche des Substrats weist gemäß dem Stand der Technik eine nicht strukturierte Kupferkaschierung (58) auf.

Auf diesen Leiterbahnen (54) sind steuerbare Leistungshalbleiterbauelemente (70 a/b) wie beispielhaft IGBTs (insulated gate bipolar Transistor) erfindungsgemäß angeordnet. Die Leistungshalbleiterbauelemente (70 a/b) weisen zu ihrem elektrischen Anschluss drei Kontaktflächen auf. Eine erste Kontaktfläche ist dem Emitteranschluss (72) des IGBTs zugeordnet, eine zweite dem Steueranschluss (74) und eine dritte dem Kollektoranschluss (76). Der Kollektoranschluss (76) ist auf der zweiten Hauptfläche des IGBTs (70 a/b) angeordnet, der Emitter- (72) und der Steueranschluss (74) sind auf der ersten Hauptfläche des IGBTs (70 a/b) angeordnet, wobei hier als Lage dieses Steueranschluss ein Eckbereich des IGBTs bevorzugt ist.

Das Leistungshalbleitermodul (1) weist erste Leistungshalbleiterbauelemente (70 a) auf deren jeweilige erste Hauptfläche dem Substrat (5) zugewandt auf diesem angeordnet ist. Die Emitterkontaktfläche (72) ist hierbei elektrisch leitend mit einer zugeordneten Lastpotential führenden Leiterbahn (54) verbunden. Die Steuerkontaktfläche (74) ist mit einer zugeordneten Hilfs- (Steuer-) Potential führenden Leiterbahn (56 a) elektrisch leitend verbunden.

Das Leistungshalbleitermodul (1) weist weiterhin zweite Leistungshalbleiterbauelemente (70 b) auf, die wie aus dem Stand der Technik bekannt, mit ihrer zweiten Hauptfläche dem Substrat (5) zugewandt auf der zugeordneten Leiterbahn (54) angeordnet sind. Diese weisen zu ihrer Ansteuerung eine Bondverbindung (40) mit einer Steuerpotential führenden Leiterbahn (56b) auf.

Es ist besonders bevorzugt die elektrisch leitende Verbindung zwischen den Leiterbahnen (54, 56 a) des Substrats (5) und den zugewandten Kontaktflächen der jeweiligen Leistungshalbleiterbauelemente (70 a/b) mittels einer elektrisch leitfähigen Klebeverbindung auszubilden, wobei andere bekannte Verfahren, wie Löten oder Drucksintern, ebenfalls geeignet sind.

Bei der genannten Anordnung der Leistungshalbleiterbauelemente (70 a/b) auf dem Substrat (5) ist dieses derart ausgebildet, dass es nur eine Lastverbindungsbahn (54) mit nur einem Potential, dem Wechselspannungspotential, aufweist. Weitere Potentiale des Substrats sind ausschließlich Steuerpotentiale (56 a/b) oder nicht dargestellte Hilfspotentiale, beispielhaft für nach dem Stand der Technik bekannte Sensorsignale.

Die Lastanschlusselemente (42, 44, 46) dienen der externen Verbindung der leistungselektronischen Schaltung im Inneren des Leistungshalbleitermoduls (1). Notwendige Hilfsanschlusselemente sind aus Gründen der Übersichtlichkeit nicht dargestellt. Erfindungsgemäß ist hier ein erstes Lastanschlusselement (44) nicht mit einer Leiterbahn sondern mit ersten Lastanschlussflächen (76), hier Kollektoranschlussflächen, erster Leistungshalbleiterbauelemente (70a) verbunden und bildet somit den Lastanschluss mit positivem Potential aus. In gleicher Weise ist ein zweites Lastanschlusselement (46) mit zweiten Lastanschlussflächen (72); hier Emitteranschlussflächen, zweiter Leistungshalbleiterbauelemente (70b) verbunden und bildet somit den Lastanschluss mit negativem Potential aus. Der Lastanschluss (42) mit Wechselstrompotential ist direkt mit der zugeordneten Leiterbahn (54) verbunden.

Diese beschriebene Anordnung ist besonders vorteilhaft, da hier keine Bondverbindungen für Lastpotentiale notwendig sind und dadurch der Herstellungsaufwand gegenüber dem Stand der Technik deutlich verringert werden kann. Weiterhin ist es besonders vorteilhaft, dass durch nur ein Lastpotential auf dem Substrat die Topologie der Leiterbahnen des Substrats (5) äußert einfach ausgestaltet ist (vgl. Fig. 2). Ebenso ist die Stromzuführung direkt zu den Leistungshalbleiterbauelementen (70 a/b) und die Stromabführung vorzugsweise mittig zwischen diesen besonders effektiv.

Es ist weiterhin besonders bevorzugt, wenn die Leistungshalbleiterbauelemente (70 a/b) auf ihren dem Substrat (5) abgewandten Lastkontaktflächen mittels einer Drucksinterverbindung angeordnete Metallformkörper (60) aufweisen. Ebenso ist es geeignet diese Metallformkörper (60) mit anderen bekannten Verfahren, wie Löten oder Kleben anzuordnen. Die Metallformkörper (60) dienen vorzugsweise zur gleichmäßigen Laststromeinprägung in das Leistungshalbleiterbauelement (70 a/b). Bei einer Drucksinterverbindung weisen die Lastkontaktflächen des Leistungshalbleiterbauelements (70 a/b) eine zur hierfür geeignete Edelmetalloberfläche, vorzugsweise aus Gold, auf. Auf dieser Lastkontaktfläche und mit dieser mittels der Drucksinterverbindung elektrisch leitend verbunden ist der Metallformkörper (60) mit den Längenabmessungen der zugeordneten Lastanschlussfläche und mit einer Dicke von weniger als 50 von 100 seiner maximalen Längenausdehnung angeordnet. Der Metallformkörper (60) selbst besteht vorzugsweise aus Kupfer und ist zumindest im Bereich der Drucksinterverbindung mit einer galvanisch aufgebrachten Edelmetalloberfläche versehen.

Eine weitere besonders bevorzugte Ausgestaltung des erfindungsgemäßen Leistungshalbleitermoduls (1) weist eine Druckkontaktierung auf. Hierbei wird mindestens ein Lastanschlusselement (44, 46), das auf einem Leistungshalbleiterbauelement (70 a/b) angeordnet ist, mittels bekannter Ausgestaltungen mit Druck (80) beaufschlagt. Somit kann sowohl eine druckkontaktierte elektrische Verbindung des Lastanschlusselements (44, 46) mit dem zugeordneten Leistungshalbleiterbauelement (70 a/b) als auch oder Alternativ eine druckkontaktierte thermische leitende Verbindung zwischen dem Substrat (5) und dem Kühlbauteil (50) ausgebildet werden.

Eine elektrische Verbindung mittels Druckkontaktierung zwischen dem Lastanschlusselement (44, 46) und dem Leistungshalbleiterbauelement (70 a/b) hat den Vorteil auch bei wechselnden Belastungen eine bekannt hohe Dauerhaltbarkeit aufzuweisen. Eine thermische Verbindung mittels Druckkontaktierung zwischen dem Substrat (5) und einem Kühlbauteil (50), wobei der Druck über das Leistungshalbleiterbauelement (70 a/b) eingeleitet wird hat die besonderen Vorteile, dass die thermische Ankopplung dort am besten ausgebildet ist wo Abwärme entsteht, nämlich am Leistungshalbleiterbauelement (70 a/b) und dass die gesamte Anordnung kompakt ausgebildet werden kann, da hier keine zusätzlichen Flächen auf dem Substrat (5) vorzuhalten sind um den Druck einzuleiten.

Im Rahmen einer Druckkontaktierung erweisen sich auch die Metallformkörper (60) als besonders vorteilhaft, da diese den Druck auf das Leistungshalbleiterbauelement (70 a/b) homogen über die jeweils zugeordnete Kontaktfläche verteilen und somit das Leistungshalbleiterbauelement (70 a/b) vor einer möglichen Beschädigung durch die Druckeinleitung (80) schützen.

Fig. 2 zeigt das Substrat (5) und die Anordnung der Leistungshalbleiterbauelemente (70 a/b) eines erfindungsgemäßen Leistungshalbleitermoduls (1). Dargestellt ist dies am Beispiel einer Halbbrückenschaltung, wie sie Grundbaustein vieler leistungselektronischen Schaltungen ist. Die Halbbrückenschaltung besteht aus 4 ersten Leistungstransistoren (70 a) mit zwei antiparallel geschalteten Leistungsdioden (70 c) (ungesteuerte Leistungshalbleiterbauelemente), die einen ersten Leistungsschalter ausbilden, der mit positivem Potential verbunden ist (vgl. Fig. 1) sowie aus einer ebensolchen Anordnung (70 b/d) für den zweiten Leistungsschalter.

Dargestellt ist weiterhin das keramische Substrat (5), hierauf angeordnet eine Laststrom mit Wechselstrompotential führende Leiterbahn (54) sowie je eine Leiterbahn (56 a/b) für die Steuersignale des ersten und des zweiten Schalters. Die gesteuerten Leistungshalbleiterbauelemente (70 a), wiederum IGBTs, des ersten Schalters sind mit ihrer ersten Hauptfläche dem Substrat (5) zugewandt angeordnet. Die Emitterkontaktflächen (72) sind auf die Wechselstrompotential führenden Leiterbahn (54) geklebt und somit elektrisch mit dieser verbunden. Die Steuerkontaktflächen (74) der ersten IGBTs (70 a) sind ebenfalls mittels einer Klebeverbindung mit der zugeordneten Steuerstrom führenden Leiterbahn (56 a) elektrisch leitend verbunden.

Es kann bevorzugt sein, wenn zwischen den Leistungshalbleiterbauelementen und den Leiterbahnen des Substrats weitere Metallformkörper angeordnet sind. Diese dienen der Beabstandung der Leistungshalbleiterbauelemente von den Leiterbahnen. Hierbei ist für jedes Potential der jeweiligen Leistungshalbleiterbauelemente ein weiterer Metallformkörper vorzusehen. Beispielhaft sind für einen IGBT (70a) je ein weiterer Metallformkörper für den Emitterkontakt bzw. für den Steuerkontakt vorzusehen.

Die gesteuerten Leistungshalbleiterbauelemente (70 b) des zweiten Schalters sind mit ihrer zweiten Hauptfläche dem Substrat (5) zugewandt angeordnet. Die Kollektorkontaktflächen (76) sind ebenfalls auf die Wechselstrompotential führende Leiterbahn (54) geklebt und somit elektrisch mit dieser verbunden. Die Steuerkontaktflächen (76) der zweiten IGBTs sind mittels je einer Bondverbindung (40) mit der zugeordneten Steuerstrom führenden Leiterbahn (56 b) elektrisch leitend verbunden.

Die nicht dargestellten Lastanschlüsse sind gemäß Fig. 1 ausgebildet.

## Patentansprüche

1. Leistungshalbleitermodul (1), zur Anordnung auf einem Kühlbauteil (50), mit mindestens einem Substrat (5), mindestens zwei steuerbaren Leistungshalbleiterbauelementen (70 a/b), einem Gehäuse (3) und nach außen führenden Last- (42, 44, 46) und Steueranschlusselementen, wobei das Substrat (5) einen Isolierstoffkörper (52) aufweist und auf dessen erster dem Inneren des Leistungshalbleitermoduls zugewandten Hauptfläche ausschließlich aber mindestens eine Lastverbindungsbahn (54) mit Wechselspannungspotential und mindestens eine Leiterbahn (56 a/b) mit Steuerpotential aufweisen, wobei die steuerbaren Leistungshalbleiterbauelemente (70 a/b) eine erste Hauptfläche mit einer ersten Lastanschlussfläche (72) und mit einer Steueranschlussfläche (74) und eine zweite Hauptfläche mit einer zweiten Lastanschlussfläche (76) aufweisen,
wobei mindestens ein erstes Leistungshalbleiterbauelement (70 a) mit seiner ersten Hauptfläche dem Substrat (5) zugewandt auf diesem angeordnet und mit je einer Wechselspannungspotential- (54) und einer Steuerpotential aufweisenden Leiterbahn (56 a) schaltungsgerecht verbunden ist und mindestens ein zweites Leistungshalbleiterbauelement (70 b) mit seiner zweiten Hauptfläche dem Substrat (5) zugewandt auf diesem angeordnet und mit einer Wechselspannungspotential aufweisenden Lastverbindungsbahn (54) schaltungsgerecht verbunden ist,
und wobei die Lastanschlusselemente (44, 46) positiven und negativen Potentials jeweils auf einer dem Substrat abgewandten Lastanschlussfläche eines zugeordneten Leistungshalbleiterbauelements (70 a/b) angeordnet und druckkontaktiert elektrisch leitend verbunden sind.

2. Leistungshalbleitermodul (1) nach Anspruch 1
wobei auf der dem Substrat (5) abgewandten Lastanschlussfläche mindestens eines Leistungshalbleiterbauelements (70 a/b) ein Metallformkörper (60) mit den Längenabmessungen der zugeordneten Lastanschlussfläche und mit einer Dicke von weniger als 50 von 100 seiner maximalen Längenausdehnung angeordnet ist.

3. Leistungshalbleitermodul (1) nach Anspruch 1,
wobei zwischen den Leistungshalbleiterbauelementen (70) und den Leiterbahnen (54, 56) des Substrats (5) weitere Metallformkörper angeordnet sind und hierbei für jedes Potential des jeweiligen Leistungshalbleiterbauelemente jeweils ein Metallformkörper vorgesehen ist.

4. Leistungshalbleitermodul (1) nach einem der vorgenannten Ansprüche,
wobei ein erstes Lastanschlusselement (44) mit ersten Lastanschlussflächen erster Leistungshalbleiterbauelemente (70 a) verbunden ist und den Lastanschluss mit positivem Potential ausbildet und ein zweites Lastanschlusselement (46) mit zweiten Lastanschlussflächen zweiter Leistungshalbleiterbauelemente (70 b) verbunden ist und den Lastanschluss mit negativem Potential ausbildet.

5. Leistungshalbleitermodul (1) nach einem der Ansprüche 1 bis 3,
wobei zusätzlich zu den gesteuerten Leistungshalbleiterbauelementen (70 a/b) auch ungesteuerte Leistungshalbleiterbauelement (70 c/f) auf der mindestens einen Leiterbahn (54) des Substrats angeordnet sind und mit den gesteuerten Leistungshalbleiterbauelementen (70 a/b) schaltungsgerecht verbunden sind.

6. Leistungshalbleitermodul (1) nach einem der vorgenannten Ansprüche,
wobei die elektrisch leitende Verbindung zwischen den Leiterbahnen (54, 56 a) des Substrats (5) und den zugewandten Kontaktflächen der Leistungshalbleiterbauelemente (70 a/b) mittels einer elektrisch leitfähigen Klebeverbindung ausgebildet ist.

7. Leistungshalbleitermodul (1) nach einem der vorgenannten Ansprüche,
wobei auf dem Substrat (5) noch weitere Leiterbahnen für Hilfs- oder Sensoranschlüsse ausgebildet sind.

8. Leistungshalbleitermodul (1) nach Anspruch 2 oder 3,
wobei die elektrisch leitende Verbindung zwischen Leistungshalbleiterbauelement (70 a/b) und Metallformkörper (60) als Drucksinterverbindung ausgebildet ist.

9. Leistungshalbleitermodul (1) nach Anspruch 2 oder 3,
wobei die elektrisch leitende Verbindung zwischen Leistungshalbleiterbauelement (70) und Metallformkörper (60) als Löt- oder Klebeverbindung ausgebildet ist.

## Claims

1. Power semiconductor module (1) for arrangement on a heatsink (50), having at least one substrate (5), at least two controllable power semiconductor elements (70 a/b), a housing (3) and load terminal elements (42, 44, 46) and control terminal elements leading to the outside, wherein the substrate (5) has an insulator body (52) and on the first main surface thereof facing the interior of the power semiconductor module, has a solely, but at least one, load connection tracks (54) with AC potential and at least one conductor track (56 a/b) with control potential,
wherein the controllable power semiconductor elements (70 a/b) have a first main surface with a first load terminal area (72) and with a control terminal surface (74), and a second main surface with a second load terminal area (76),
wherein at least one first power semiconductor element (70 a) is arranged on said substrate with the first main surface thereof facing the substrate (5), and connected in a circuit-based manner to a conductor track (56 a) having both AC potential (54) and control potential, and wherein at least a second power semiconductor element (70 b) is arranged on said substrate with the second main surface thereof facing the substrate (5) and is connected in a circuit-based manner to a load connection track (54) having AC potential, and
wherein the positive and negative potential load terminal elements (44, 46) are each arranged on a load terminal area of an associated power semiconductor element (70 a/b) facing away from the substrate and connected in an electrically conducting manner by pressure contact.

2. Power semiconductor module (1) according to Claim 1,
wherein on the load terminal area facing away from the substrate (5) of at least one power semiconductor element (70 a/b) a metallic shaped body (60) is arranged, with the length dimensions of the associated load terminal area and with a thickness of less than 50 parts per 100 of the maximal length expansion thereof.

3. Power semiconductor module (1) according to Claim 1,
wherein between the power semiconductor elements (70) and the conductor tracks (54, 56) of the substrate (5), additional metallic shaped bodies are arranged, in such a way that for each potential of the respective power semiconductor element one metallic shaped body is provided respectively.

4. Power semiconductor module (1) according to one of the preceding claims,
wherein a first load terminal element (44) is connected to first load terminal areas of first power semiconductor elements (70 a) and forms the positive potential load terminal, and a second load terminal element (46) is connected to second load terminal areas of second power semiconductor elements (70 b) and forms the negative potential load terminal.

5. Power semiconductor module (1) according to one of Claims 1 to 3,
wherein in addition to the controlled power semiconductor elements (70 a/b), uncontrolled power semiconductor elements (70 c/f) are also arranged on the at least one conductor track (54) of the substrate and connected to the controlled power semiconductor elements (70 a/b) in a circuit-based manner.

6. Power semiconductor module (1) according to one of the preceding claims,
wherein the electrically conducting connection between the conductor tracks (54, 56 a) of the substrate (5) and the facing contact surfaces of the power semiconductor elements (70 a/b) is constructed by means of an electrically conductive adhesive bond.

7. Power semiconductor module (1) according to one of the preceding claims,
wherein further additional conductor tracks are constructed on the substrate (5) for auxiliary or sensor terminals.

8. Power semiconductor module (1) according to Claim 2 or 3,
wherein the electrically conducting connection between power semiconductor element (70 a/b) and metallic shaped body (60) is constructed in the form of a pressure sintering connection.

9. Power semiconductor module (1) according to Claim 2 or 3,
wherein the electrically conducting connection between power semiconductor element (70) and metallic shaped body (60) is constructed in the form of a soldered or adhesive joint.

## Revendications

1. Module semi-conducteur de puissance (1), destiné à être agencé sur un composant de refroidissement (50), comportant au moins un substrat (5), au moins deux composants semi-conducteurs de puissance (70 a/b) commandables, un boîtier (3) et des éléments de raccordement de charge (42, 44, 46) et de commande passant à l'extérieur, le substrat (5) comportant un corps isolant (52) et, sur sa première surface principale proche de l'intérieur du module semi-conducteur de puissance, exclusivement mais au moins une piste de liaison de charge (54) avec potentiel de tension alternative et au moins une piste conductrice (56 a/b) avec potentiel de commande, les composants semi-conducteurs de puissance (70 a/b) commandables comportant une première surface principale avec une première surface de raccordement de charge (72) et avec une surface de raccordement de commande (74) et une deuxième surface principale avec une deuxième surface de raccordement de charge (76), dans lequel au moins un premier composant semi-conducteur de puissance (70 a) est agencé, avec sa première surface principale près du substrat (5), sur ledit substrat et est relié de manière conforme au circuit à une piste conductrice de potentiel de tension alternative (54) et à une piste conductrice de potentiel de commande (56 a) et au moins un deuxième composant semi-conducteur de puissance (70 b) est agencé, avec sa deuxième surface principale près du substrat (5), sur ledit substrat et est relié de manière conforme au circuit à une piste de liaison de charge (54) ayant le potentiel de tension alternative, et dans lequel les éléments de raccordement de charge (44, 46) de potentiels positif et négatif sont agencés respectivement sur une surface de raccordement de charge, éloignée du substrat, d'un composant semi-conducteur de puissance (70 a/b) associé et sont reliés d'une manière électriquement conductrice par un contact par pression.

2. Module semi-conducteur de puissance (1) selon la revendication 1,
dans lequel un corps métallique mis en forme (60) ayant les dimensions longitudinales de la surface de raccordement de charge associée et une épaisseur de moins de 50 % de son extension longitudinale maximale est agencé sur la surface de raccordement de charge, éloignée du substrat (5), d'au moins un composant semi-conducteur de puissance (70 a/b).

3. Module semi-conducteur de puissance (1) selon la revendication 1,
dans lequel d'autres corps métalliques mis en forme sont agencés entre les composants semi-conducteurs de puissance (70) et les pistes conductrices (54, 56) du substrat (5) et dans lequel un corps métallique mis en forme est alors prévu pour chaque potentiel du composant semi-conducteur de puissance respectif.

4. Module semi-conducteur de puissance (1) selon l'une des revendications précédentes,
dans lequel un premier élément de raccordement de charge (44) est relié à des premières surfaces de raccordement de charge de premiers composants semi-conducteurs de puissance (70 a) et forme le raccordement de charge avec potentiel positif et dans lequel un deuxième élément de raccordement de charge (46) est relié à des deuxièmes surfaces de raccordement de charge de deuxièmes composants semi-conducteurs de puissance (70 b) et forme le raccordement de charge avec potentiel négatif.

5. Module semi-conducteur de puissance (1) selon l'une des revendications 1 à 3,
dans lequel, en plus des composants semi-conducteurs de puissance commandés (70 a/b), des composants semi-conducteurs de puissance non commandés (70 c/f) sont aussi agencés sur l'au moins une piste conductrice (54) du substrat et sont reliés, de manière conforme au circuit, aux composants semi-conducteurs de puissance commandés (70 a/b).

6. Module semi-conducteur de puissance (1) selon l'une des revendications précédentes,
dans lequel la liaison électriquement conductrice entre les pistes conductrices (54, 56 a) du substrat (5) et les surfaces de contact proches des composants semi-conducteurs de puissance (70 a/b) est conçue au moyen d'une liaison collée électriquement conductrice.

7. Module semi-conducteur de puissance (1) selon l'une des revendications précédentes,
dans lequel d'autres pistes conductrices destinées à des raccordements auxiliaires ou de capteurs sont conçues sur le substrat (5).

8. Module semi-conducteur de puissance (1) selon la revendication 2 ou 3,
dans lequel la liaison électriquement conductrice entre le composant semi-conducteur de puissance (70 a/b) et le corps métallique mis en forme (60) est conçue comme une liaison frittée sous pression.

9. Module semi-conducteur de puissance (1) selon la revendication 2 ou 3,
dans lequel la liaison électriquement conductrice entre le composant semi-conducteur de puissance (70) et le corps métallique mis en forme (60) est conçue sous la forme d'une liaison brasée ou collée.
